# EUROPEAN PATENT SPECIFICATION

(11) **EP 2 870 269 B1**
(45) Date of publication and mention of the grant of the patent: **02.09.2020**
(21) Application number: 13736615.9
(22) Date of filing: 02.07.2013
(51) Int. Cl.: C23C 4/00, C23C 8/00, C23C 14/00, B22F 3/11, C23C 12/02

(54) **Method for Producing Long-Lasting Antibacterial Metallic Surfaces**
VERFAHREN ZUR HERSTELLUNG LANGLEBIGER ANTIBAKTERIELLER METALLOBERFLÄCHEN
PROCÉDÉ DE PRODUCTION DE SURFACES MÉTALLIQUES ANTIBACTÉRIENNES DE LONGUE DURÉE

(30) Priority: 05.07.2012 GB 201211976
(43) Date of publication of application: 13.05.2015
(73) Proprietor: The University of Birmingham, Edgbaston Birmingham West Midlands B15 2TT (GB)
(72) Inventor: DONG, Hanshan, Birmingham West Midlands B15 2TT (GB); LI, Xiaoying, Birmingham West Midlands B15 2TT (GB); DONG, Yangchun, Birmingham West Midlands B15 2TT (GB); TIAN, Linhai, Edgbaston Birmingham B15 2TT (GB)
(74) Representative: Elsy, David
(86) International application number: PCT/GB2013/051745
(87) International publication number: WO 2014/006390

(56) References cited:
- US-A1- 2005 241 736
- DONG Y ET AL: "Surface microstructure and antibacterial property of an active-screen plasma alloyed austenitic stainless steel surface with Cu and N; Surface microstructure and antibacterial property of an active-screen plasma alloyed austenitic stainless steel surface", BIOMEDICAL MATERIALS, INSTITUTE OF PHYSICS PUBLISHING, BRISTOL, GB, vol. 5, no. 5, 1 October 2010 (2010-10-01) , page 54105, XP020184949, ISSN: 1748-605X, DOI: 10.1088/1748-6041/5/5/054105
- YANGCHUN DONG ET AL: "The generation of wear-resistant antimicrobial stainless steel surfaces by active screen plasma alloying with N and nanocrystalline Ag", JOURNAL OF BIOMEDICAL MATERIALS RESEARCH PART B: APPLIED BIOMATERIALS, vol. 9999B, 1 January 2010 (2010-01-01), pages NA-NA, XP055101754, ISSN: 1552-4973, DOI: 10.1002/jbm.b.31573

## Description

### Field

The invention relates to long-lasting antibacterial metallic surfaces, in particular to long-lasting antibacterial metallic surfaces comprising silver and/or copper doped superhard S-phase and to methods for producing the long-lasting antibacterial metallic surfaces.

### Background

Silver (Ag) and its compounds are some of the strongest bactericides because biologically active silver ions can inactivate bacteria by interacting with thiol groups of bacterial proteins and enzymes [1]. The first documented use of silver as an antibacterial agent can date back to 1881 when silver nitrate was used for prevention of gonococcal ophthalmia neonatorun [2]. Silver has since been researched and as a result has found some applications such as Ag-containing PMMA bone cement, Ag-containing in dwelling catheters, wound dressings and stainless steel fixation devices [3, 4]. Similarly, copper (Cu) has also been used historically throughout the world as a hygienic material because Cu also has antimicrobial effects [5].

Currently there are two methods to form Ag or Cu-containing antibacterial surfaces on metallic materials by: (1) alloying bulk materials surface with silver and (2) coating the substrate with an Ag or Cu-containing composite thin layer. In the first approach, ion implantation is used to dope a metal surface with Ag or Cu [6]. However, the implanted surface layer is normally < 0.5µm and hence the durability is very poor due to unavoidable wear and tear in application. In addition, ion implantation is a line-of-sight process and hence it is difficult, if not impossible, to homogeneously treat components with complex 3-D shapes.

The second approach, Ag-containing coatings, is the most researched method and some commercial processes, such as AgION™, are available to coat stainless steel surfaces. However, the AgION™ is essentially an Ag-doped polymer coating and therefore it is designed for non-tribological applications with poor durability [7]. Attempts have been made by some researchers to produce Ag or Cu-ceramic composite coatings to increase wear resistance such as PACVD deposited thin Ag-DLC composite coating [8] or thermal sprayed Ag-TiO₂ composite coating [9]. However, the antibacterial effect of such thin coatings cannot last long mainly due to their low load-bearing capacity and the expected short durability; the durability of antibacterial effect of sprayed coatings is limited by their porous nature and very low bonding to the substrate. Failure of such coatings will lead to fast leaching of Ag or Cu ions and the resulted detrimental toxic effect.

Active screen plasma (ASP) technology has been described previously in the generation of highly durable antimicrobial surfaces by combining a wear-resistant S-phase with nanocrystalline silver for medical grade stainless steel [10].

It is an object of the present invention to develop novel surface engineering technologies, which can enable the above-mentioned disadvantages to be obviated or mitigated, to generate highly effective, long-lasting and minimal leaching antimicrobial metallic surfaces. This has been achieved by plasma surface co-alloying (for example by ASP co-alloying) with interstitial elements (such as N, C or N/C) to form hard and wear resistant S-phase and with substitutional elements (such as Ag, Cu or Ag/Cu) to form an antibacterial agent reservoir for slow and continual release of Ag, Cu or both Ag and Cu for prolonged antimicrobial effect.

### Description of the invention

The present invention is defined in the appended claims. The invention provides novel plasma surface engineering technologies based on modifying a surface characteristic of a stainless steel or Co-Cr alloy, with both substitutional (Ag, Cu, or Ag/Cu) and interstitial (C, N, or N/C) alloying elements at a temperature in the range of from 300 to 600°C and at a pressure of from 100 to 1500 Pa for 1 to 50 hours in an atmosphere comprising N-containing, C-containing or N/C-containing gas; wherein a biased target source comprising Ag, Cu or Ag/Cu is introduced as an additional source cathode to achieve varying percentages of Ag, Cu or Ag/Cu by adjusting the bias applied to the additional source cathode; for the generation of novel multifunctional surfaces with high hardness, high wear resistance, good corrosion resistance and long-lasting and high antibacterial efficacy. The novel long-lasting antibacterial stainless steel surfaces can be used for medical devices (such as medical instruments and implants) to prevent post-operation infection, for hospital equipment to avoid hospital acquired infection and for food processing facilities to reduce food poison as well as for kitchen wares to improve hygiene.

Plasma surface alloying has been used for more than 20 years to enhance the surface properties of ferrous materials. Recently, low-temperature plasma surface alloying of austenitic stainless steels and Co-Cr alloys with such interstitial alloying elements as carbon and nitrogen has been shown to achieve improvement in the combined properties of corrosion, wear and fatigue through the formation of interstitial highly supersaturated expanded austenite, i.e. S-phase [11]. This S-phase layer is very hard (800-1200HV) and wear resistant resulting in high durability under wear conditions. Therefore, S-phase layer could be an ideal substrate for long-lasting antimicrobial surfaces. However, it is almost impossible to generate an effective antimicrobial surface layer using conventional DC or RF plasma surface alloying with Ag and/or Cu because it is impossible to form a stable Ag/Cu plasma at temperatures below 450°C and the diffusion of substitutional Ag/Cu elements is very slow at such low-temperature.

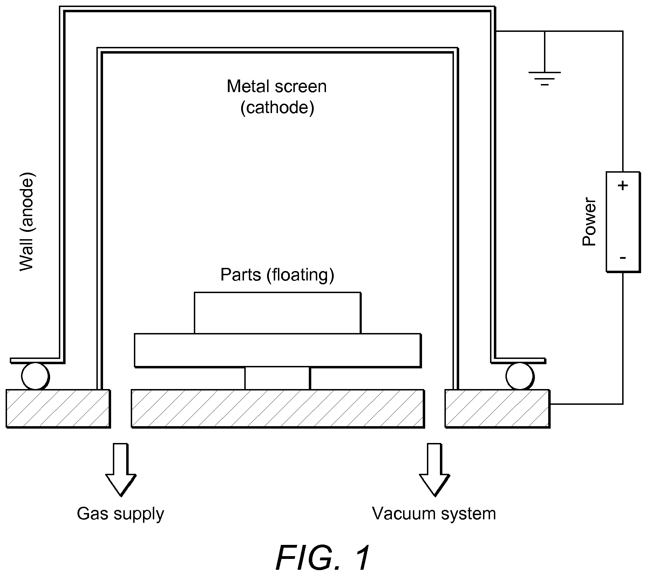

An advanced active screen plasma (ASP) technology (Fig.1) has become available in which substantially the entire workload is substantially surrounded by a metal screen, on which a high voltage cathodic potential is applied and the plasma forms (hence the term "Active Screen" is used). The parts to be treated are placed at floating potential or subjected to a relatively low bias voltage. The plasma formed on the screen contains a mixture of metal ions, electrons and other active species, which are then encouraged to flow through the screen and over the workload by a specially designed gas flow and/or electric field (if a bias is applied). Recent research by the inventors has found that 'sputtering and redeposition' is a dominant mass transfer mechanism [12]. For example, during the ASP nitriding process using a steel mesh screen, N⁺ ions from plasma near the screen are accelerated to strike the cathodic metal screen surface and thus detach or sputter steel atoms into the plasma to form FeN particles, which are then deposited onto parts surface. Subsequently, the deposited FeN is decomposed into Fe₂₋₃N and Fe₄N and the active nitrogen atoms thus released diffuse into a stainless steel or Co-Cr alloy surface to form N or C S-phase if low-temperature is used.

According to the present invention, there is provided a method of co-alloying stainless steel or Co-Cr alloy surfaces simultaneously with (i) N, C or C/N to form hard and wear/corrosion resistant S-phase and (ii) interstitial and substitutional alloying elements, typically with Ag, Cu or Ag/Cu to confer antibacterial effect, by modifying plasma surface technology, such as ASP technology, with a purpose designed composite or hybrid metal screen comprising stainless steel or Co-Cr alloy mesh mixed with Ag, Cu or Ag/Cu at a temperature in the range of from 300 to 600°C and at a pressure of from 100 to 1500 Pa for 1 to 50 hours in an atmosphere comprising N-containing, C-containing or C/N-containing gases.

Stainless steels typically have a minimum of 11 weight % chromium by mass. The chromium typically forms a passive film of chromium oxide which blocks corrosion from spreading into the metals internal structure. Typically at least 13% or up to 26% chromium is used.

The stainless steel may be ferritic or martensitic but is typically austentistic. Nickel may be added to stablise the austentistic structure of iron in the steel. Manganese may also be added to the stainless steel. Duplex stainless steels containing a mixed microstructure of austenite and ferrite may be used.

Such stainless steels are generally known in the art.

Cobalt-chrome alloys typically have high strength and may be used in gas turbines, dental implants and orthopaedic implants. Typically they have cobalt with 27 to 30 weight % chromium, 5 to 7 weight % molybdenum, less than 1% iron, less than 0.75% nickel and limits on other elements such as manganese, silicon, carbon, nitrogen, tungsten, phosphorous, sulphur and boron. The industry standard is ASTM-F75 or ASTM-F799.

The surface characteristic to be modified by the method of the present invention may be any one or more of hardness, wear resistance, corrosion resistance, fatigue strength and high antibacterial efficacy.

Preferably, said composite or hybrid metal screen, whole screen or part of a screen, comprises stainless steel (for surface treatment of stainless steel articles) or Co-Cr alloy (for surface treatment of Co-Cr articles) and 10-70 wt% Ag, Cu or both Ag and Cu, and may be made by hot isostatic pressing (HIPping) of stainless steel or Co-Cr micro powders with Ag/Cu nano powders at temperature between 700 and 1000°C under a pressure of 60-120 MPa for 1-5 hours followed by machining if necessary.

Alternatively, said composite or hybrid metal screen comprising stainless steel (for surface treatment of stainless steel articles) or Co-Cr alloy (for surface treatment of Co-Cr articles) and 10-70 wt% Ag, Cu or both Ag and Cu, may be made by weaving austenitic stainless steel or Co-Cr alloy and Ag/Cu strips or by wiring austenitic stainless steel or Co-Cr alloy mesh with Ag/Cu strips.

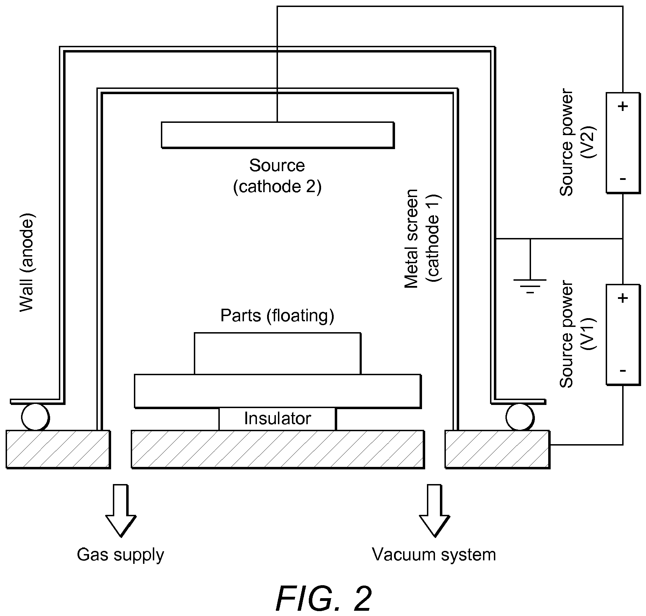

A biased target source comprising Ag, Cu or Ag/Cu is introduced into typical ASP equipment as an additional source cathode (Figure 2). The substitutional elements from both the screen (made from the substrate material) and the source (Ag, Cu or Ag/Cu) will be sputtered out and deposited onto the surface of the parts; in the meantime, interstitial elements (N, C or N/C) diffuse into the deposited nanocomposite and the substrate. Thus, a long-lasting anti-bacterial stainless steel or Co-Cr alloy surface with varying percentage of Ag, Cu or Ag/Cu can be generated by adjusting the bias applied to the additional source cathode.

Preferably, said article is a medical implant, such as a joint or knee prosthesis, in which case said plasma treating is preferably carried out at a temperature in the range of from 350 to 550°C, and more preferably 400 to 500°C. At these temperatures, the method generally confers antibacterial efficacy, increases wear resistance and enhances corrosion resistance.

Alternatively, said article may be a medical tool (such as surgical or dental tool) or component for food processing and hospital facilities, in which case said plasma treating is typically carried out at a temperature in the range of from 350 to 550°C, more typically 400 to 500°C. At these temperatures, the method generally confers high antibacterial efficacy, significantly increases wear resistance but not necessarily corrosion resistance.

Typically, said treatment pressure is in the range of from 400 to 600 Pa and is more typically about 500 Pa; the duration of said treatment is in the range of from 1 to 50 hours and more typically 5 to 30 hours.

Typically, the plasma treatment is carried out in the presence of at least one unreactive gas, for example selected from hydrogen, helium, argon or other noble gas. As used herein "unreactive" relates to a gas which does not become incorporated into the article to any significant extent.

The plasma treatment is carried out in the presence of at least one reactive gas, wherein the reactive gas is an N-containing gas (e.g. N2 or ammonia) or a C-containing gas (e.g. CO or CH₄). As used herein "reactive" relates to a gas which (or a part of which) does become incorporated into the article to a certain extent. Where an N-containing gas is used, the plasma treating step is typically effected at a temperature of from 350 to 450°C.

Particularly preferred gas mixtures are hydrogen and methane for carburising, nitrogen and hydrogen for nitriding, and methane, nitrogen and hydrogen for nitrocarburising.

Typically, the or each carbon-containing gas constitutes from 0.5 to 20% by volume of the total atmosphere. Typically, said reactive gas (when present) constitutes from 0.5 to 10% by volume of the total atmosphere.

Typically, the or each N-containing gas constitutes from 10 to 40% by volume of the total atmosphere. Preferably, said N-containing gas (when present) constitutes from 20 to 30% by volume of the total atmosphere. Typically the concentration of the N- or C-containing gas is substantially homogenous across the chamber.

Typically, the or each C-containing gas constitutes from 0.5 to 10% by volume of the total atmosphere. Preferably, said C-containing gas (when present) constitutes from 1 to 5% by volume of the total atmosphere.

A surface-alloyed stainless steel or cobalt-chromium based article may be producible or obtainable by the method of the present invention, said article characterised by having a surface region comprising (i) a thin S-phase layer embedded by Ag-, Cu or Ag/Cu and (ii) a thicker S-phase case. Preferably, said surface region has a thickness in the range of from 1 to 50 µm.

Composite or hybrid screens for use in the invention and ASP devices containing them are also described.

### Brief description of the drawings

Embodiments of the present disclosure will now be described by way of example only, with reference to the accompanying drawings and specific examples hereafter.
Fig 1 is a schematic view of an active screen plasma unit with composite or hybrid metal screen in which the co-alloying described in the preferred embodiments below was effected,
Fig 2 is a schematic view of an active screen plasma unit with an additional source cathode in which the co-alloying according to the invention can be effected,
Fig 3 shows SEM micrographs of the cross-sectional microstructure of a 316L test piece co-alloyed with Ag and nitrogen in accordance with the present disclosure,
Fig 4 shows depth distribution of (a) Ag and (b) N in 15-h active-screen Ag and N co-alloyed (nitro-silvered) 316L test piece as a function of treatment temperature,
Fig 5 is (A) TEM micrograph and (B) SAD patterns showing nano Ag particles embedded in S-phase layer in AS plasma nitro-silvered 316LVM surface; TEM micrograph (C) showing nano Cu particles embedded in S-phase layer in AS plasma nitro-coppered 316LVM surface, Figs 6-8 are graphs showing the hardness and wear resistance of untreated test pieces and test pieces surface hardened in accordance with the present disclosure :
Fig 6 Effect of treatment parameters on the microhardness of LTASDP nitropsilvered 316LVM surface.
Fig 7 Wear rate and wear depth of wear track on LTASP intro-silvered 316LVM surface.
Fig 8 Wear rate of the LTASP nitrocoppered (CuNSS) 316,316LVM and High-N 316 surfaces as comparison with untreated stainless steels.
Figs 9-11 are graphs showing the anti-bacterial properties of untreated test pieces and test pieces surface hardened in accordance with the present disclosure :
Fig 9 E.coli spread plate results of:
   (a) control of single S phase layer (NSS), (b) AgNSS 400 400/15, and (c) AgNSS 450/15.
Fig 10 Reduction rate of E. coli and S. epidermidis on LTASP nitro-coppered CuNSS, LTASP nitrided NSS and control (coverslip).
Fig 11 Reduction percentage of bacteria on circularly washed steels.

Typical examples of suitable stainless steel and Co-Cr based alloys which are susceptible to the process of the present invention are summarised in Table 1. The stainless steel and Co-Cr based alloys of which the article is formed may be in the wrought, cast or PM/HIP form before the article is subjected to the process to the present invention.

**TABLE 1: Examples of useful stainless steel and Co-Cr alloys**

| ***Materials*** | ***Cr*** | ***Mo*** | ***Ni*** | ***W*** | ***C*** | ***Si*** | ***Mn*** | ***Fe*** | ***Co*** | ***others*** |
|---|---|---|---|---|---|---|---|---|---|---|
| *AISI300 austenitic stainless steels* | | | | | | | | | | |
| 304 | 19-21 | - | 8-12 | - | <0.08 | 1 | 2 | bal | - | |
| 310 | 24-26 | - | 19-22 | - | <0.25 | 1.5 | 2 | bal | - | |
| 316 | 16-18 | 2-3 | 10-14 | - | <0.08 | 1 | 2 | bal | - | |
| 316L | 16-18 | 2-3 | 10-14 | - | <0.03 | 1 | 2 | bal | - | |
| 321 | 17-19 | - | 9-12 | - | <0.08 | 1 | 2 | bal | - | >(5x%C)Ti |

| *Medical grade austenitic stainless steels* | | | | | | | | | | |
|---|---|---|---|---|---|---|---|---|---|---|
| F138 (LVM) | 17-19 | 2-3 | 13-15 | - | <0.03 | <0.75 | <2 | bal | - | <0.1 N |
| F2581 (Ni-free) | 16-18 | 3-4 | <0.05 | - | <0.25 | <0.6 | 10-13 | bal | - | 0.45-0.55N |
| F1586 (high-N) | 20-22 | 2-3 | 9-11 | - | <0.08 | <0.75 | 2-4 | bal | - | 0.25-0.50N |

| *Medical grade Co-Cr alloys* | | | | | | | | | | |
|---|---|---|---|---|---|---|---|---|---|---|
| F75 | 27-30 | 5-7 | <1 | - | <0.35 | <1 | <1 | <0.75 | bal | |
| F799 | 26-30 | 5-7 | <1 | - | <0.35 | <1 | <1 | <1.5 | bal | |
| F90 | 19-21 | - | 9-11 | 13-16 | <0.15 | <0.4 | 1-2 | <3 | bal | |
| F562 | 19-21 | 9-11 | 33-37 | - | <0.15 | <0.15 | <0.15 | <1 | bal | |

Three austenitic stainless steels, 316, 316LVM and high-N, were co-alloyed with nitrogen and Ag (nitro-silvering) or Cu (nitro-coppering) using an ASP apparatus shown in Figure 1. The apparatus comprises a sealable vessel (anode), a vacuum system with a rotary pump (not shown), a dc power supply, a gas supply system, a temperature measurement system (not shown), a stainless steel mesh screen containing silver or copper as the composite cathode screen (active screen), and a work table at a floating potential (i.e. zero bias) for supporting articles to be treated.

The treatment parameters and the sample codes are summarised in Table 2. To produce control samples, a conventional ASP facility with a stainless steel mesh cylinder was also used for the low-temperature plasma nitriding (LTPN) of austenitic stainless steel surface without any antimicrobial agent (see NSS in Table 2). The articles were then subjected to SEM and TEM analysis for metallography analysis and phase identification, glow discharge spectrometry (GDS) analysis for chemical composition determination, surface hardness measurements, wear tests and antibacterial tests.

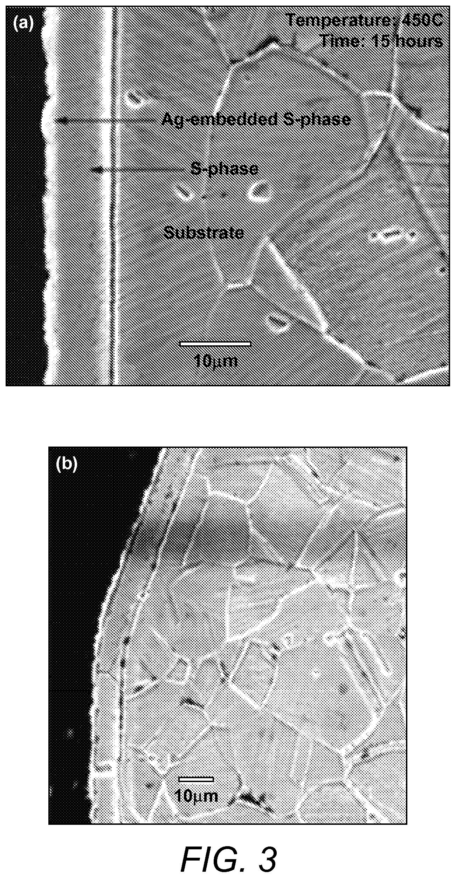

The cross-sectional micrographs in Figure 3 show the typical appearance of the layers from surface to substrate produced by ASP co-alloying. It can be seen that the surface of steel had been significantly changed when it was treated at 450°C for 15 hours, i.e. a double-layer was formed over the austenitic substrate. The double-layer surface comprised a white layer at the surface with a thickness of about 0.8-1.0µm, and a thick zone between the white layer and substrate with a thickness of 10 µm (Fig.3a). The zone appeared smooth and featureless in morphology, and contained no visible grain boundaries inside the layer. It can be seen that the double-layer structure homogeneously covered the whole sample surface, as shown in Fig.3b. The steels treated at 400 and 500°C for 15h and at 450°C for 20h were also cross sectioned and examined microscopically. The surface white layer appeared to be uniform (∼1 µm) regardless of increasing temperature.

**TABLE 2: Examples of treatment parameters and sample codes**

| **Code** | **Screen (%)** | | | **Gas (%)** | | **Time** | **Temp.** | **Substrate** | **Note** |
|---|---|---|---|---|---|---|---|---|---|
| | **ASS** | **Ag** | **Cu** | **H₂** | **N₂** | **h** | **°C** | | |
| NSS | 100 | 0 | 0 | 75 | 25 | 15 | 450 | 316LVM | Control |
| AgNSS 400/15 | 40 | 60 | 0 | 75 | 25 | 15 | 450 | 316LVM | Nitro-silvering |
| AgNSS 450/15 | 40 | 60 | 0 | 75 | 25 | 15 | 450 | 316LVM | |
| AgNSS 450/20 | 40 | 60 | 0 | 75 | 25 | 20 | 450 | 316LVM | |
| AgNSS 500/15 | 40 | 60 | 0 | 75 | 25 | 15 | 450 | 316LVM | |
| CuNSS_25 | 40 | 0 | 60 | 75 | 25 | 15 | 450 | * | Nitro-coppering |
| CuNSS_75 | 40 | 0 | 60 | 25 | 75 | 15 | 450 | * | |

| | | | | | | | | | |
|---|---|---|---|---|---|---|---|---|---|
| NB: *316, 316LVN or high-N | | | | | | | | | |

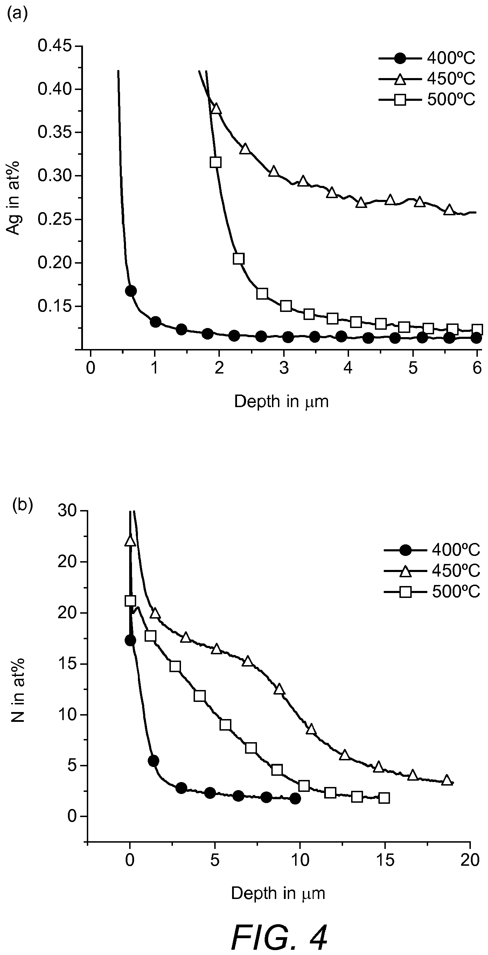

Fig. 4 shows typical GDOES elemental depth profiles of Ag and N and the influences of treatment temperature on the elemental distribution of Ag and N through the multilayers. It can be seen that the N depth profile exhibited a plateau type shape with steep leading edges, while Ag depth profile exhibited similar shape but with a much smaller thickness. The thickness of the Ag rich layer appeared to be constant at 1 µm regardless of the increase in temperature, whereas N was significantly affected by the treatment, i.e. when steel was treated at 400°C, diffusion depth of N was very small (<5µm). But when temperature increased to 450°C, nitrogen diffusion depth increased from less than 5µm to 15µm as defined by GDOES. When temperature further increased to 500°C, nitrogen depth decreased again from 15µm down to about 12µm and the N concentration decreased more rapidly than that for the steel treated at 450°C.

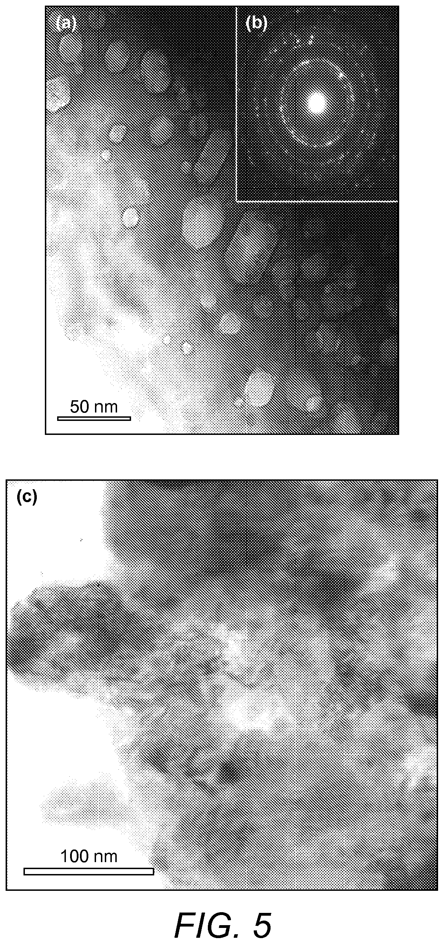

XRD analysis revealed Ag and S-phase peaks from the ASP nitro-silvered 316LVM surfaces and Cu and S-phase peaks from the ASP nitro-coppered 316LVM surfaces. TEM studies confirmed that the multilayer structure produced by low temperature ASP nitro-silvering and nitro-coppering consisted of nano crystalline Ag (Fig.5A) and Cu respectively embedded in S-phase (Fig. 5C).

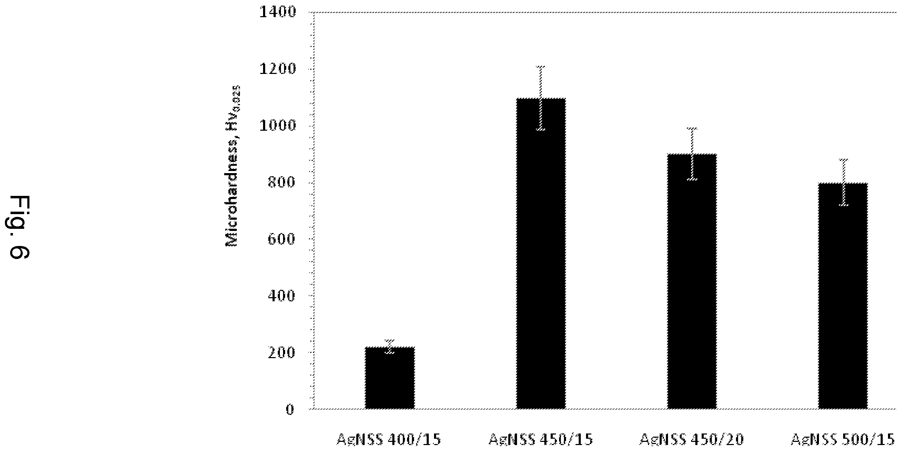

The effect of the treatment conditions on surface microhardness profiles are depicted in Figure 6. It is clear that 450°C ASP nitro-silvered specimens produced effective hardening up to 800-1000 HV0.025. The steel treated at 400°C showed a low hardness with value of 220 HV0.025 very similar to the untreated steel. The surface hardness of the 450°C ASP nitro-coppered CuNSS_25 and CuNSS_75 is about 1200 HV0.025.

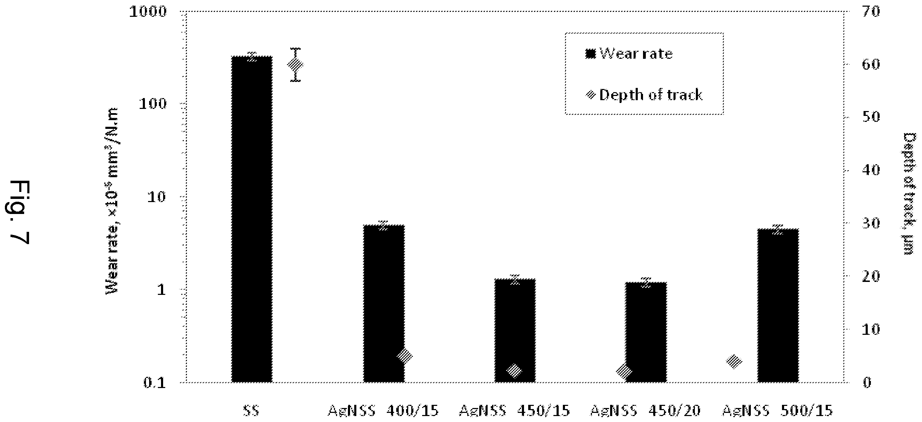

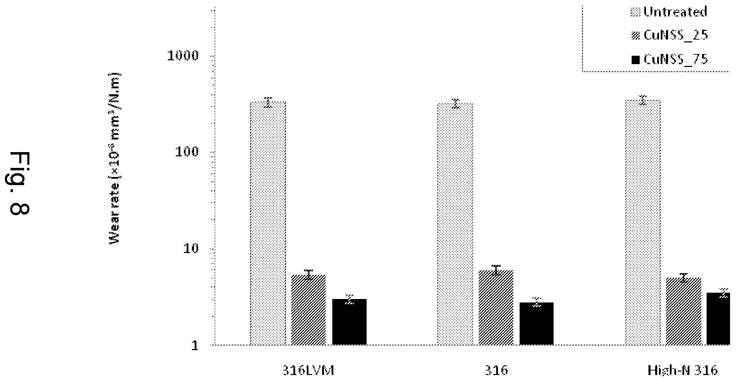

Figure 7 compares the wear properties of ASP nitro-silvered stainless steel treated at 400, 450 and 500°C. Wear resistance of AgNSS 450/15 was improved by more than two orders of magnitude compared with the untreated SS sample. Judging from the wear track depth, the Ag-rich layer was unlikely to have been completely worn off after completion of the wear test. Similar improvement has also been achieved by ASP nitro-coppering for three medical grade ASSs (Fig. 8).

The *in vitro* antibacterial behaviours of stainless steel surfaces co-alloyed with Ag and N (nitro-silvering) or with Cu and N (nitro-coppering) were evaluated. The cover slip was used as control and the NSS was used as control of Ag-free or Cu-free (i.e. S-phase only).

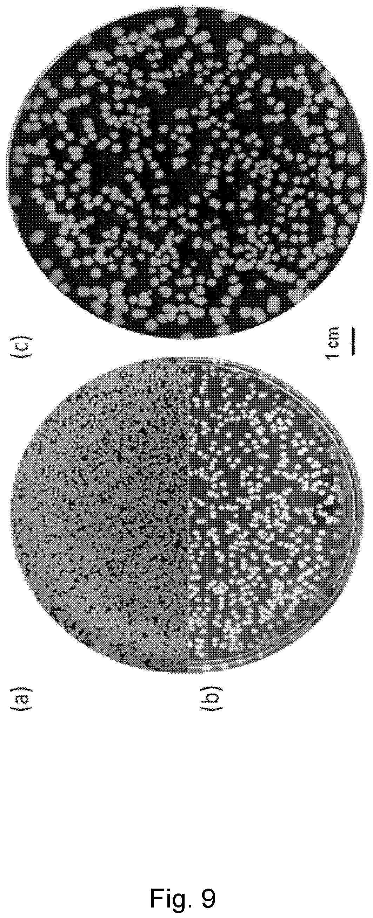

Figures 9(a) and (b) show two halves of two separate Petri dishes covered with bacteria of E. coli. Figure 9(a) is from specimen with S-phase only (NSS) and (b) is from AgNSS 400/15. They both are controls for comparison with the steel alloyed with AgNSS 450/15 (c). It can be seen that the dish (a) was almost completely covered by bacterial colonies where as on (b) and (c) there were few. Colonies shown in (b) and (c) were larger because there was less competition for nutrients when fewer bacteria were present.

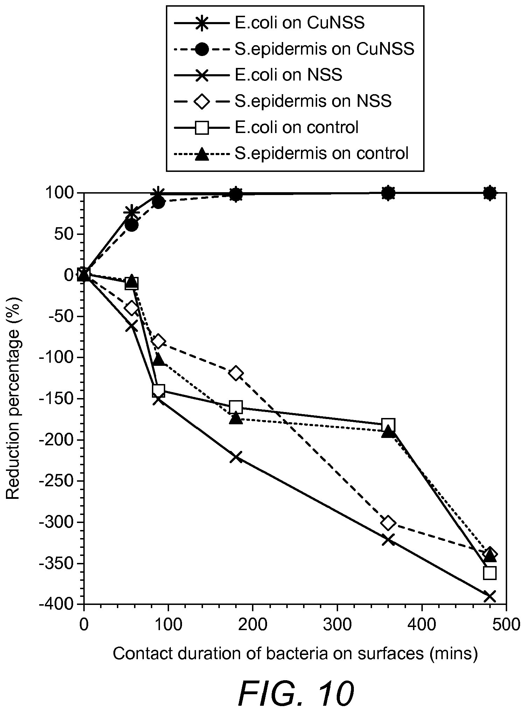

The ASP nitro-coppered CuNSS surface was very effective in inhibiting many spectrums of bacteria, quickly and thoroughly. Figure 10 shows the reduction rate of gram negative E. coli and gram positive S. epidermidis on CuNSS. Compared with the Cu-free NSS and cover slip controls, there was significant difference. After 180 mins (3h), more than three-fold rises of bacterial number on the NSS and control surfaces were found, but no viable cells were detected on the CuNSS (killing percentage of 100%). It is worth noting that there was a difference between the reduction rate of E. coli and S. epidermidis on the surface of CuNSS: the E. coli reduced by 75% and 98%, respectively, after 60 mins and 90 mins, whereas the S. epidermidis cells reduced by 60% and 90% respectively.

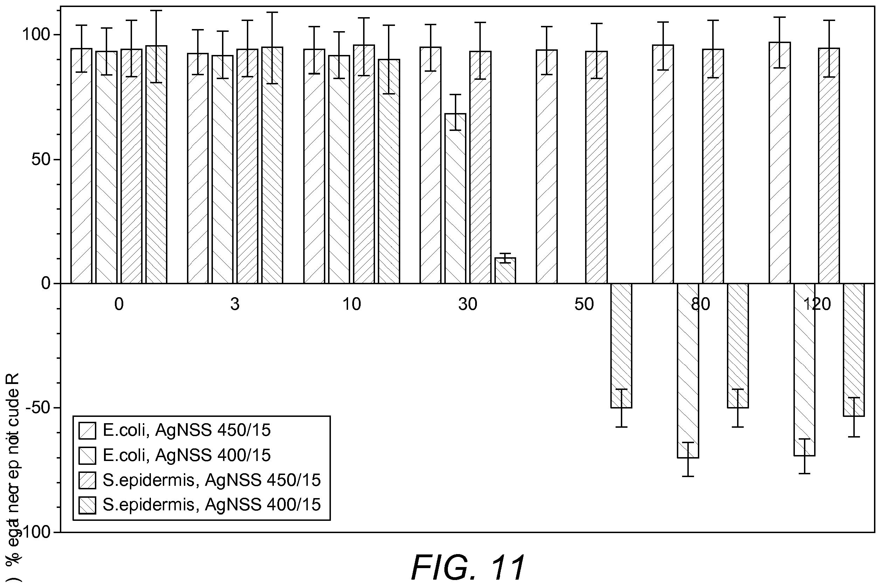

To evaluate the *in vitro* durability of antibacterial activity of alloyed surfaces, dynamic susceptibility observation was accomplished using system washing and sterilizing that corresponded to hospital routine cleaning, and spread plate tests were carried out at intervals to evaluate viability. The antibacterial properties of surfaces after 3, 10, 30, 50, 80 and 120 times of test-cleaning cycles are shown in Figure 11. In the first 10 cycles, two groups of samples kept high antibacterial activity and the bacterial reduction of E. coli balanced at 92%. After around 50 cycles, the silver activity of AgNSS 400/15 was not maintained and the killing percentage of E. coli and S. epidermidis dropped to 70% and 50%, respectively. In contrast, AgNSS 450/15 maintained at 92%, 92% and 95% after 10, 50, 80 intervals, and after the final cycle, the average reduction percentages of E. coli and S. epidermidis cells were retained at 96% and 94% respectively.

### References

1 Q.L. Feng et al., Journal Biomaterials Research, 52(2000), 662-668.
2 C. Crede, Die Verhütung der Augenentzundung der Neugeborenen, Archiv für Gynaekologie, 17(1881), 50-53.
3 D.W. Brett, A discussion of silver as an antimicrobial agent, Ostomy Wound Management, 52 (2006), 34-41.
4 M. Bosetti, A. Masse, E. Tobin and M. Cannas, Silver coated materials for external fixation devices, in vitro biocompatibility and genotoxicity, Biomaterials, 23 (2002), 887-892.
5 R. Duguid, Copper-inhibition of the growth of oral streptococci and actinomyces Biomaterials, 4(1983), 225-7.
6 Y. Z. Wan, S. Raman, F. He and Y. Huang, Surface modification of medical metals by ion implantation of silver and copper, Vacuum, 81(2007), 1114-8.
7 M.M. Cowan et al., Antimicrobial efficacy of a silver-zeolite matrix coating on stainless steel, Journal of Industrial Microbiology and Biotechnology, 30(2003), 102-106.
8 F.R. Marciano et al., Antibacterial activity of DLC and Ag-DLC films produced by PECVD technique, Diamond and Diamond Related Materials, 18(2009), 1010-1014.
9 B. Li et al., Preparation and anti-bacterial properties of plasma sprayed nano-titania/silver coatings, Materials Chemistry and Physics, 118(2009), 99-104
10 Y. Dong et al., The generation of wear-resistant antimicrobial stainless steel surfaces by active screen plasma alloying with N and nanocrystalline Ag, Journal of Biomedical Materials Research Part B: Applied Biomaterials, 93(2010), 185-93.
11 H. Dong, S-phase engineering of Fe-Cr, Co-Cr and Ni-Cr alloys, International Materials Review, 55(2010), 65-98.
12 S. Corujeira Gallo, H. Dong, Vacuum, 84 (2010), 321-325.

## Claims

1. A method of modifying a surface characteristic of a stainless steel or cobalt-chromium (Co-Cr) based alloy article, comprising plasma surface co-alloying the article, with both interstitial and substitutional alloying elements at a temperature in the range of from 300 to 600°C and at a pressure of from 100 to 1500 Pa for 1 to 50 hours in an atmosphere comprising N-containing, C-containing or N/C-containing gas; wherein a biased target source comprising Ag, Cu or Ag/Cu is introduced as an additional source cathode to achieve varying percentages of Ag, Cu or Ag/Cu by adjusting the bias applied to the additional source cathode.

2. The method of claim 1, wherein the interstitial alloying element is N, C or both N and C for forming hard and wear/corrosion resistant S-phase and the substitutional alloying element is Ag, Cu or both Ag and Cu for conferring antibacterial efficacy.

3. The method of claim 1, wherein the surface characteristic to be modified is one or more of hardness, wear resistance, corrosion resistance, fatigue strength and antibacterial property.

4. The method of claim 1, wherein the active screen plasma unit contains a composite or hybrid metal screen such as a whole screen or part of a screen, comprising stainless steel mesh or Co-Cr alloy mesh mixed with Ag, Cu or both Ag and Cu at a concentration ranging from 10 to 70 wt%, preferably wherein the composite or hybrid metal screen is made by hot isostatic pressing (HIPping) of stainless steel or Co-Cr micro powders with Ag/Cu nano powders at temperature between 700 and 1000°C under a pressure of 60-120MPa for 1-5 hours; or preferably wherein the composite or hybrid metal screen is made by weaving austenitic stainless steel or Co-Cr alloy and Ag/Cu strips or by wiring austenitic stainless steel or Co-Cr alloy mesh with Ag/Cu strips.

5. The method of claim 1, 2 or 3, wherein the article whose surface characteristic is to be modified is a medical implant, such as a joint or knee prosthesis, preferably wherein the plasma treating is carried out at a temperature in the range of from 350 to 550°C, more preferably wherein the plasma treating is carried out at a temperature in the range of from 400 to 500°C.

6. The method of claim 1, 2 or 3, wherein the article whose surface characteristic is to be modified is a medical tool (such as surgical or dental tool) or component for food processing and hospital facilities, preferably wherein the plasma treating is carried out at a temperature in the range of from 400 to 650°C, more preferably wherein the plasma treating is carried out at a temperature in the range of from 450 to 550°C.

7. The method of any preceding claim, wherein said treatment pressure is in the range of from 400 to 600 Pa.

8. The method of any preceding claim, wherein the duration of said treatment is in the range of from 1 to 50 hours, preferably wherein the duration of said treatment is in the range of from 5 to 30 hours.

9. The method of any preceding claim, wherein the plasma treatment is carried out in the presence of at least one unreactive gas selected from hydrogen, helium, argon or other noble gas, preferably wherein the unreactive gas is hydrogen or a mixture of hydrogen and argon, and the carbon-containing gas is methane.

10. The method of any preceding claim, wherein the plasma treatment is carried out in the presence of at least one reactive gas.

11. The method of claim 10, wherein the reactive gas is a nitrogen containing gas; or wherein the reactive gas is a carbon containing gas.

12. The method of claim 10, wherein the plasma treatment is effected at a temperature in the range of from 300 to 500°C.

13. The method of any one of claims 10 to 12, wherein said reactive gas constitutes from 0.5 to 30% by volume of the total atmosphere.

14. The method of any preceding claim, wherein the or each carbon-containing gas constitutes from 0.5 to 20% by volume of the total atmosphere.

## Patentansprüche

1. Verfahren zum Modifizieren der Oberflächeneigenschaft eines Gegenstandes aus einer Legierung auf der Basis von Edelstahl oder Kobalt-Chrom (Co-Cr), umfassend das Plasma-Oberflächenlegieren des Gegenstandes mit sowohl Zwischengitter- als auch Substitutions-Legierungselementen bei einer Temperatur im Bereich von 300 bis 600 °C und bei einem Druck von 100 bis 1500 Pa für 1 bis 50 Stunden in einer Atmosphäre, die N-haltiges, C-haltiges oder N/C-haltiges Gas umfasst; wobei eine unter einer Vorspannung stehende Targetquelle, die Ag, Cu oder Ag/Cu umfasst, als eine zusätzliche Quellkathode eingeführt wird, um durch Einstellen der an die zusätzliche Quellkathode angelegten Vorspannung wechselnde Prozentsätze von Ag, Cu oder Ag/Cu zu erreichen.

2. Verfahren nach Anspruch 1, wobei das Zwischengitter-Legierungselement N, C oder N und C ist, um eine harte und verschleiß-/korrosionsbeständige S-Phase zu bilden, und das Substitutions-Legierungselement Ag, Cu oder sowohl Ag als auch Cu ist, um eine antibakterielle Wirksamkeit zu verleihen.

3. Verfahren nach Anspruch 1, wobei die zu modifizierende Oberflächeneigenschaft eine oder mehrere der Eigenschaften Härte, Verschleißfestigkeit, Korrosionsbeständigkeit, Ermüdungsfestigkeit und antibakterielle Eigenschaft ist.

4. Verfahren nach Anspruch 1, wobei die Aktivgitter-Plasmaeinheit ein Verbund- oder Hybrid-Metallgitter als ganzes Gitter oder Teilgitter enthält, das ein Netz aus rostfreiem Stahl oder einer Co-Cr-Legierung, gemischt mit Ag, Cu oder Ag und Cu in einer Konzentration im Bereich von 10 bis 70 Gew.-%, umfasst, wobei das Verbund- oder Hybrid-Metallgitter vorzugsweise durch isostatisches Heißpressen (HIPping) von Mikropulvern aus rostfreiem Stahl oder Co-Cr mit Ag/Cu-Nanopulvern bei einer Temperatur zwischen 700 und 1000 °C unter einem Druck von 60-120 MPa für 1-5 Stunden hergestellt wird; oder wobei das Verbund- oder Hybridmetallgitter vorzugsweise durch Weben von Bändern aus austenitischem Edelstahl oder einer Co-Cr-Legierung und aus Ag/Cu oder durch Verflechten eines Siebs aus austenitischem rostfreiem Stahl oder einer Co-Cr-Legierung mit Ag/Cu-Bändern hergestellt wird.

5. Verfahren nach Anspruch 1, 2 oder 3, wobei der Gegenstand, dessen Oberflächeneigenschaft modifiziert werden soll, ein medizinisches Implantat, wie eine Gelenk- oder Knieprothese, ist, wobei die Plasmabehandlung vorzugsweise bei einer Temperatur im Bereich von 350 bis 550°C durchgeführt wird, wobei die Plasmabehandlung besonders bevorzugt bei einer Temperatur im Bereich von 400 bis 500°C durchgeführt wird.

6. Verfahren nach Anspruch 1, 2 oder 3, wobei der Gegenstand, dessen Oberflächeneigenschaft modifiziert werden soll, ein medizinisches Werkzeug (wie ein chirurgisches oder zahnärztliches Werkzeug) oder ein Bauteil für Lebensmittelverarbeitungs- und Krankenhauseinrichtungen ist, wobei die Plasmabehandlung vorzugsweise bei einer Temperatur im Bereich von 400 bis 650°C durchgeführt wird, wobei die Plasmabehandlung besonders bevorzugt bei einer Temperatur im Bereich von 450 bis 550°C durchgeführt wird.

7. Verfahren nach einem der vorstehenden Ansprüche, wobei der Behandlungsdruck im Bereich von 400 bis 600 Pa liegt.

8. Verfahren nach einem der vorstehenden Ansprüche, wobei die Dauer der Behandlung im Bereich von 1 bis 50 Stunden liegt, wobei die Dauer der Behandlung vorzugsweise im Bereich von 5 bis 30 Stunden liegt.

9. Verfahren nach einem der vorstehenden Ansprüche, bei dem die Plasmabehandlung in Gegenwart mindestens eines nicht reaktiven Gases, ausgewählt aus Wasserstoff, Helium, Argon oder einem anderen Edelgas, durchgeführt wird, wobei das nicht reaktive Gas vorzugsweise Wasserstoff oder eine Mischung aus Wasserstoff und Argon ist und das kohlenstoffhaltige Gas Methan ist.

10. Verfahren nach einem der vorstehenden Ansprüche, wobei die Plasmabehandlung in Gegenwart von mindestens einem reaktiven Gas durchgeführt wird.

11. Verfahren nach Anspruch 10, wobei das reaktive Gas ein stickstoffhaltiges Gas ist; oder wobei das reaktive Gas ein kohlenstoffhaltiges Gas ist.

12. Verfahren nach Anspruch 10, wobei die Plasmabehandlung bei einer Temperatur im Bereich von 300 bis 500°C durchgeführt wird.

13. Verfahren nach einem der Ansprüche 10 bis 12, wobei das reaktive Gas 0,5 bis 30 Vol.-% der Gesamtatmosphäre ausmacht.

14. Verfahren nach einem der vorhergehenden Ansprüche, wobei das oder jedes kohlenstoffhaltige Gas 0,5 bis 20 Vol.-% der Gesamtatmosphäre ausmacht.

## Revendications

1. Procédé pour modifier une caractéristique de surface d'un article en acier inoxydable ou d'un alliage à base de cobalt-chrome (Co-Cr) consistant à :
- allier par co-alliage au plasma la surface de l'article avec à la fois des éléments d'alliage interstitiel et de substitution à une température dans une plage comprise entre 300 et 600°C et une pression comprise entre 100 et 1500 Pa pendant 1 à 50 heures dans une atmosphère comprenant un gaz contenant N, un gaz contenant C ou un gaz contenant N/C,
- une source cible, polarisée avec Ag/Cu ou Ag/Cu étant introduite comme cathode source additionnelle pour permettre de varier les pourcentages de Ag, Cu ou Ag/Cu en réglant la polarisation appliquée à la cathode source additionnelle.

2. Procédé selon la revendication 1,
selon lequel
l'élément d'alliage interstitiel est N, C ou à la fois N et C pour former une phase S dure et résistant à l'usure / corrosion et l'élément d'alliage de substitution est Ag, Cu ou à la fois Ag et Cu pour avoir une efficacité antibactérielle.

3. Procédé selon la revendication 1,
selon lequel
la caractéristique de surface à modifier est l'une ou plusieurs des caractéristiques suivantes : dureté, résistance à l'usure, résistance à la corrosion, résistance à la fatigue et propriété antibactérielle.

4. Procédé selon la revendication 1,
selon lequel
l'unité d'écran de plasma actif contient un écran composite ou en métal hybride tel qu'un écran complet ou une partie d'écran avec des mailles en acier inoxydable ou des mailles en alliage Co-Cr, mélangé avec Ag, Cu ou à la fois Ag et Cu avec une concentration allant de 10 à 70 % pondéraux, de préférence l'écran composite ou en métal hybride étant réalisé par compression isostatique à chaud (HIPping) de micropoudres d'acier inoxydable ou de Co-Cr ave des nanopoudres Ag/Cu à une température comprise entre 700°C et 1000°C sous une pression de 60 à 120 MPa pendant une durée de 1 à 5 heures ; ou de préférence,
l'écran composite ou en métal hybride est réalisé par le tissage d'acier inoxydable austénitique ou d'alliage Co-Cr et de rubans Ag/Cu ou encore par câblage d'acier inoxydable austénitique ou d'une maille d'alliage Co-Cr avec des rubans Ag/Cu.

5. Procédé selon les revendications 1, 2 ou 3,
selon lequel
l'article dont la caractéristique de surface doit être modifiée est un implant médical tel qu'une prothèse d'articulation ou de genou,
de préférence dans lequel
le traitement au plasma est effectué à une température de l'ordre de 350-550 °C et de manière plus préférentielle, le traitement au plasma est effectué à une température dans une plage de 400 à 500°C.

6. Procédé selon la revendication 1, 2 ou 3,
selon lequel
l'article dont la caractéristique de surface doit être modifiée est un outil médical (tel qu'un outil chirurgical ou dentaire) ou encore un composant pour un traitement alimentaire ou une installation d'hôpital, de préférence le traitement au plasma est effectué à une température de l'ordre de 400-650°C et de façon plus préférentielle, le traitement au plasma est effectué à une température dans une plage comprise entre 450 et 550°C.

7. Procédé selon l'une quelconque des revendications précédentes, selon lequel
la pression de traitement est dans une plage de 400-600 Pa.

8. Procédé selon l'une quelconque des revendications précédentes, selon lequel
la durée du traitement est de l'ordre de 1 à 50 heures, de préférence, la durée du traitement est de l'ordre de 5 à 30 heures.

9. Procédé selon l'une quelconque des revendications précédentes,
selon lequel
le traitement au plasma est effectué en présence d'au moins un gaz non réactif choisi dans le groupe comprenant hydrogène, hélium, argon ou autres gaz nobles, de préférence, le gaz non réactif est de l'hydrogène ou un mélange d'hydrogène et d'argon et le gaz contenant du carbone est le méthane.

10. Procédé selon l'une quelconque des revendications précédentes,
selon lequel
le traitement au plasma est effectué en présence d'au moins un gaz réactif.

11. Procédé selon la revendication 10,
selon lequel
le gaz réactif est un gaz contenant de l'azote ou le gaz réactif est un gaz contenant du carbone.

12. Procédé selon la revendication 10,
selon lequel
le traitement au plasma est effectué à une température de l'ordre de 300-500°C.

13. Procédé selon l'une quelconque des revendications 10 à 12,
selon lequel
le gaz de réaction représente de 0,5 à 30% en volume de l'atmosphère totale.

14. Procédé selon l'une quelconque des revendications précédentes,
selon lequel
le ou chaque gaz contenant du carbone représentent entre 0,5 et 20 % en volume de l'atmosphère totale.
